# EUROPEAN PATENT APPLICATION

(11) **EP 3 243 808 A1**
(43) Date of publication of application: **15.11.2017**
(21) Application number: 17170363.0
(22) Date of filing: 10.05.2017
(51) Int. Cl.: C04B 41/00, C04B 41/87, C04B 41/50, C04B 41/89, B32B 18/00, C23C 28/04, C04B 111/00

(54) **HIGH TEMPERATURE COATING FOR SILICON NITRIDE ARTICLES**

(30) Priority: 11.05.2016 US 201615151836
(71) Applicant: United Technologies Corporation, Farmington, CT 06032 (US)
(72) Inventor: Smyth, Imelda P., N. Palm Beach, FL Florida 33408 (US); Page, Ralph E., Jupiter, FL Florida 33458 (US); Barron, Alan C., Jupiter, FL Florida 33458 (US)
(74) Representative: de Bresser, Sara Jean

(57) **Abstract**

A coated article, comprising an article having at least one surface having disposed thereupon an oxidation resistant coating comprising at least two constituents to form a composition, a first constituent comprising at least one thermal expansion component comprising at least about 10% by volume to up to about 99% by volume of the composition, a second constituent comprising at least one oxygen scavenger comprising at least about 1% by volume to up to about 90% by volume of the composition.

## Description

### BACKGROUND

The disclosure relates to coatings and, more particularly, to oxidation protection coatings for silicon nitride articles.

Advanced turbine engines that are currently being pursued for enhanced performance and improved operational efficiencies require stable lightweight materials with robust mechanical properties across a wide temperature spectrum, that is, from a room temperature of 65°F (18°C) to operating temperatures of 1,200°F (650°C) to 3,000°F (1,650°C) and greater. Due to these stringent demands, only a limited number of refractory materials such as carbon or ceramic materials, carbon fiber or silicon carbide fiber based composites, monolithic ceramics such as silicon nitride and silicon carbide and refractory based alloys such as those based on molybdenum and niobium can be used. While possessing adequate high temperature mechanical properties, these materials all suffer from inadequate high temperature oxidation resistance.

Most approaches for creating oxidation protective coatings consider the use of silica (SiO₂) based high melting point glasses and therefore are not expected to provide protection in the range of 1200°F (650°C) to 3000°F (1650°C). When teaching the use of refractory silicides for providing an oxidation resistant coating, most approaches frequently require forming high melting silicide compounds or eutectic mixtures of silicides with or without free silicon as disclosed in U.S.P.N. 7,060,360 to Eaton, et al., assigned to United Technologies Corporation and incorporated by reference herein in its entirety.

As described in U.S.P.N. 5,677,060 to Terentieva, these silicide coatings are created in-situ by high temperature annealing steps that form silica films at high temperatures. In service, such coatings may tend to form complex scales involving mixtures of silica, metal silicates and metal oxides. The combination of these phases (along with the substrate metal silicides themselves) may exacerbate the problems associated with differences in the various coefficients of thermal expansion.

Commercially available coatings for protecting C/SiC substrates typically provide good oxidation protection up to 3000°F (1650°C), but significantly decrease the strength of the underlying substrate.

Therefore, there still exists a need for stable refractory metal based protective coatings exhibiting high temperature oxidation resistance.

### SUMMARY OF THE INVENTION

In accordance with the present disclosure, there is provided, a process for applying an oxidation resistant coating to an article (e.g. a process for producing an article as described herein). The process comprises mixing at least two constituents to form a composition, a first constituent comprising a thermal expansion component comprising at least about 10% by volume to up to about 99% by volume of the composition, a second constituent comprising an oxygen scavenger comprising at least about 1% by volume to up to about 90% by volume of the composition. The process includes coating an article with the composition to form a coated article; and heat treating under an inert atmosphere the coated article to form an article having at least one oxidation resistant coating layer containing the at least one oxygen scavenger.

In another and alternative embodiment, the composition is selected from the group consisting of Si/SiOC, Ti/SiC, SiC/SiOC, yttrium disilicate/SiOC, SiC/Si/SiOC, Si/SiC and Si/Si3N4.

In another and alternative embodiment, the article comprises silicon nitride.

In another and alternative embodiment, at least one oxygen scavenger is a silicide of any one or more of the following: molybdenum, tantalum, chromium, titanium, hafnium, zirconium, yttrium, and mixtures thereof; or a boride of any one or more of the following: molybdenum, tantalum, chromium, titanium, hafnium, zirconium, yttrium, and mixtures thereof; or both of any one or more of the silicides and any one or more of the borides.

In another and alternative embodiment, at least one oxygen scavenger is a silicide of any one of the following: molybdenum, tantalum, chromium, titanium, hafnium, zirconium, yttrium, and mixtures thereof; and a boride of any one of the following: molybdenum, tantalum, chromium, titanium, hafnium, zirconium, yttrium, and mixtures thereof.

In another and alternative embodiment, the mixing comprises a mechanical mixing process comprising at least one of the following: ball mixing, grinding, high energy milling, attrition milling, centrifugal mixing, and combinations thereof.

In another and alternative embodiment, the coating comprises at least one of the following processes: co-spraying, thermal spraying, chemical vapor deposition, physical vapor deposition, electrophoretic deposition, electrostatic deposition, preceramic polymer pyrolysis, sol-gel, slurry coating, dipping, air-brushing, sputtering, painting, and combinations thereof.

In another and alternative embodiment, the process further comprises drying the coated article at about 662°F (350°C) for about 30 minutes to about 60 minutes prior to heat treating the coated article.

In another and alternative embodiment, the heat treating comprises heating the coated article at about 1,000°F (538°C) to about 3,100°F (1,700°C) for a period of time sufficient to form the oxidation resistant coating.

In another and alternative embodiment, the silica based material comprises a particle size range of about 150 mesh to about 325 mesh.

In another and alternative embodiment, the at least one oxygen scavenger comprises a particle diameter size range of about 0.05 microns to about 50 microns.

In another and alternative embodiment, the process further comprises applying upon the oxidation resistant coating layer a top coat layer comprising at least one of the following: refractory oxide material, refractory carbide material, refractory boride material, refractory silicide material, and mixtures thereof.

In another and alternative embodiment, the refractory oxide material is selected from the group consisting of TaₓOy (where x = 1 to 3 and y = 1 to 5), NbₓOy (where x = 1 to 3 and y = 1 to 5), MgO, CaO, SrO, BaO, SiO₂, HfO₂, TiO₂, ZrO₂, Al₂O₃, Y₂O₃, La₂O₃, rare earth oxides, and mixtures thereof.

In another and alternative embodiment, the applying comprises at least one of the following processes: thermal spraying, chemical vapor deposition, physical vapor deposition, electrophoretic deposition, electrostatic deposition, preceramic polymer pyrolysis, sol-gel, slurry coating, dipping, air-brushing, sputtering, slurry painting, high velocity oxygen fuel spraying, and low pressure plasma spraying.

In accordance with another aspect of the present disclosure a coated article (e.g. a coated article formed by a process as herein described) comprising an article having at least one surface having disposed thereupon an oxidation resistant coating comprising at least two constituents to form a composition, a first constituent comprising at least one thermal expansion component comprising at least about 10% by volume to up to about 99% by volume of the composition, a second constituent comprising at least one oxygen scavenger comprising at least about 1% by volume to up to about 90% by volume of the composition.

In another and alternative embodiment, the composition is selected from the group consisting of Si/SiOC, Ti/SiC, SiC/SiOC, yttrium disilicate/SiOC, SiC/Si/SiOC, Si/SiC and Si/Si3N4.

In another and alternative embodiment, the at least one oxygen scavenger is a silicide of any one or more of the following: molybdenum, tantalum, chromium, titanium, hafnium, zirconium, yttrium, and mixtures thereof; or a boride of any one or more of the following: molybdenum, tantalum, chromium, titanium, hafnium, zirconium, yttrium, and mixtures thereof; or both of any one or more of the silicides and any one or more of the borides.

In another and alternative embodiment, a top coat layer disposed upon the oxidation resistant coating, the top coat layer comprising at least one of the following: refractory oxide material, refractory carbide material, refractory boride material, refractory silicide material, and mixtures thereof.

In another and alternative embodiment, the refractory oxide material is selected from the group consisting of TaₓOy (where x = 1 to 3 and y = 1 to 5), NbₓOy (where x = 1 to 3 and y = 1 to 5), MgO, CaO, SrO, BaO, SiO₂, HfO₂, TiO₂, ZrO₂, Al₂O₃, Y₂O₃, La₂O₃, rare earth oxides, and mixtures thereof.

In another and alternative embodiment, the article comprises any one of the following: silicon containing ceramics, silicon containing alloys, and mixtures thereof.

In another and alternative embodiment, the silicon containing ceramics are selected from the group consisting of silicon nitride, silicon carbide, silicon carbonitride, silicon oxycarbides, silicon carbide composites, silicon nitride composites, silicon oxynitrides, silicon aluminum oxynitrides, silicon nitride ceramic matrix composites, and mixtures thereof.

In another and alternative embodiment, the silicon containing alloys are selected from the group consisting of molybdenum silicon alloys, niobium silicon alloys, iron silicon alloys, iron silicon alloys, cobalt silicon alloys, nickel silicon alloys, tantalum silicon alloys, refractory metal silicon alloys, and mixtures thereof.

In another and alternative embodiment, the oxidation resistant coating has a thickness of between about 0.1 and about 300 mils.

In another and alternative embodiment, the oxidation resistant coating has a thickness of between about 0.1 and about 10 mils.

In another and alternative embodiment, the article comprises any one of the following: turbine engine components, hypersonic engine components, and hypersonic components.

In another and alternative embodiment, the article comprises any one of the following: nozzles, flaps, seals and shrouds of turbine engines; leading edges and heat exchangers of hypersonic engines; and airfoil surfaces of hypersonic components.

The details of one or more embodiments of the disclosure are set forth in the accompanying drawings and the description below. Other features, objects, and advantages of the invention will be apparent from the description and drawings, and from the claims.

### BRIEF DESCRIPTION OF THE DRAWINGS

FIG. 1 is a representation of a flowchart of the current process;
FIG. 2 is a representation of an article coated with an oxidation resistant coating; and
FIG. 3 is a representation of an article coated with multiple layers of the oxidation resistant coating.
Like reference numbers and designations in the various drawings indicate like elements.

### DETAILED DESCRIPTION

The exemplary protective coatings protect refractory materials from oxidation in a range of temperatures from room temperature to up to at least about 3000°F (1650°C) and greater. The exemplary protective coatings take advantage of glass materials having low melting point temperatures in combination with oxygen scavenging additives to achieve high mechanical and oxidation resistant properties required by the refractory based substrate. Although especially applicable to low thermal expansion composite substrates such as C/SiC, SiC/SiC or SiC/SiNC and monolithic Si₃N₄, the basic architecture of the protective coatings described herein is also applicable to all refractory materials requiring oxidation protection over a broad temperature range to ensure optimal performance.

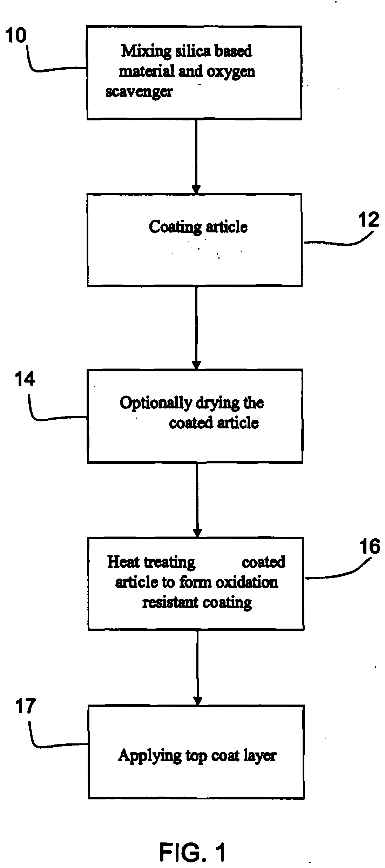

Referring now to FIG. 1, a flowchart representing an exemplary process is shown. A process for applying an oxidation resistant coating may comprise mixing two or more constituents. In an exemplary embodiment the coating can include at least about 10% by volume to up to about 99% by volume of at least one silica based material and at least about 1% by volume to up to about 90% by volume of at least one oxygen scavenger at a step 10 of FIG. 1. Suitable mixing processes may include, but are not limited to, mechanical mixing techniques, manual mixing techniques, ultrasonics, cavitation, agitation, combinations comprising these techniques, and the like. For example, representative mechanical mixing techniques may include grinding, ball mixing, high energy milling (e.g., Spex), shear mixing, stirring, centrifugal mixing, combinations comprising at least one of the foregoing, and the like.

Suitable silica based materials may comprise silica, modified silica, and the like. Modified silica may comprise silica modified by other compounds or elements, for example, silicates such as sodium silicate, borosilicates, hafnium silicates, zirconium silicates, and mixtures thereof.

The coating constituents can comprise Si/SiOC, Ti/SiC, SiC/SiOC, yttrium disilicate/SiOC, SiC/Si/SiOC, Si/SiC and Si/Si3N4.

The oxidation resistant coating of the present invention provides oxidation resistance primarily by active reaction with oxygen rather than only providing a passive barrier to oxygen flow to an article's surface. As the coating(s) are exposed to oxidative operating conditions, the coating(s) erodes and exposes the oxygen scavenger additives. The oxygen scavengers oxidize to form non-gaseous oxidation products such as SiO₂, Al₂O₃, B₂O₃, etc., which then add to and rebuild the coating. The glassy phase flows at elevated temperature to seal cracks and accommodate mismatches of the coefficient of thermal expansion of the various layers. As a result, the coating in turn resists spallation and cracking and instead relieves the stress caused by the formation of the non-gaseous oxidation products.

The oxygen scavenger or getter may be defined to be any element or compound or multiphase component that reacts with oxygen to form a relatively stable, non volatile oxygen-containing compound or phase. Suitable oxygen scavengers may comprise silicides and/or borides of aluminum, molybdenum, tantalum, chromium, titanium, hafnium, zirconium, yttrium, mixtures thereof, and the like. In an exemplary embodiment, Si, Ti and SiOC can comprise the oxygen gettering mechanism. In addition, other refractory metals, and other metals that form refractory oxides, silicates, borides, and mixtures thereof, may also be utilized as suitable oxygen scavengers. The volume % of the oxygen scavenger within the layers of coating may preferably be in the range of about 1% to about 90% by volume of the layers of coating, and more preferably in the range of about 5% to about 75% by volume of the layers of coating.

In order to establish proper compatibility in the coefficient of thermal expansion between the coating and the substrate, SiC and yttrium disilicate provide thermal expansion compatibility with silicon nitride.

Referring again to FIG. 1, a substrate may be coated at step 12. The substrate may comprise an article for which the desired oxidation protection is sought. Any one or more of a number of coating techniques known to one of ordinary skill in the art may be utilized. For example, suitable coating techniques may include, but are not limited to, co-spraying, thermal spraying, chemical vapor deposition, physical vapor deposition, electrophoretic deposition, electrostatic deposition, preceramic polymer pyrolysis, sol-gel, slurry coating, dipping, air-brushing, sputtering, painting or any combination thereof. In addition, suitable coating techniques may also include high velocity oxygen fuel processes, low pressure plasma spray processes, and the like. When applying multiple layers of oxidation resistant coatings, particularly suitable coating techniques include polymer impregnation processes, chemical vapor deposition processes, physical vapor deposition processes, and combinations thereof. Each oxidation resistant coating(s) should be disposed upon the article at a thickness of greater than or equal to about 0.05 mils (0.00005 inch), preferably between about 0.1 to about 300 mils and ideally between about 0.1 to about 10 mils.

When utilizing certain coating processes, the liquid medium remains and may form a film or residue upon the coated substrate. If such residue(s) remain, the coated substrate may be dried at step 14 of FIG. 1 such that the residue is oxidized and "burned out". For example, the coated substrate may be dried at about 350°C for about 30 minutes to about 60 minutes. Optionally, steps 12 and 14 may be repeated as often as necessary to achieve the desired thickness, coating weight, other desired properties, and the like, of a coating layer prior to heat treating the coated article at step 16 of FIG. 1.

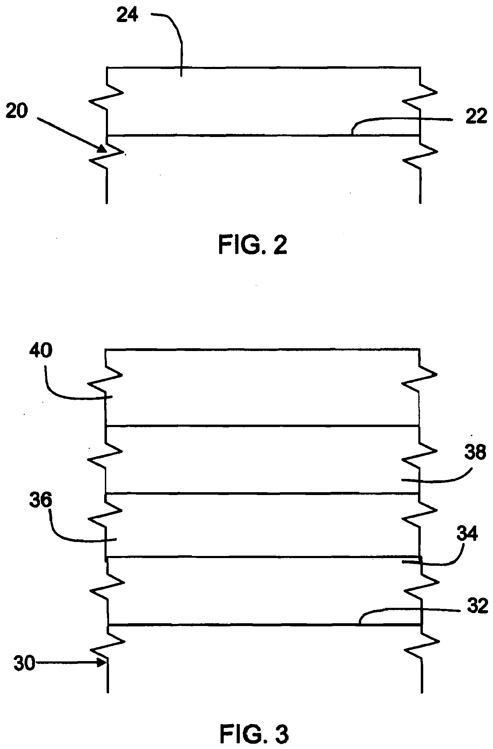

The process of the present invention may be repeated so as to form at least one layer of the oxidation resistant coating described herein, that is, multiple layers of oxidation resistant coatings as shown in FIG. 3. For example, steam protection may be imparted by the use of a top layer comprising a steam resistant material, such as the aforementioned viscosity modifiers, as known to one of ordinary skill in the art.

Referring again to FIG. 1, the coated substrate may be heat treated to form the oxidation resistant coating of the present invention at step 16. The reaction product of the silica based material(s), oxygen scavenger(s) and optional alkaline earth material additive(s) form a layer of glass containing the oxygen scavengers dispersed through the layer. The heat treatment may be carried out using any one of a number of techniques known to one of ordinary skill in the art. The heat treatment temperature range may preferably be about 932°F (500°C) to about 3,272°F (1,800°C), and depends on the constituents of the slurry. For example, a substrate coated with a silica-based glass and an oxygen scavenger may require being heat treated in a temperature range of about 1,000°F (538°C) to about 1,500°F (816°C) for a period of time sufficient to form the oxidation resistant coating. Optionally, steps 14 and 16 may be repeated as necessary, prior to applying the top coat layer at step 17. The top coat layer can comprise an oxide overlay, such as yttrium disilicate.

Referring now to FIGS. 2 and 3, an article coated with the oxidation resistant coating of the present invention is shown. An article 20 may comprise any part, component of a part, etc. that requires protection from oxidation across a temperature range of about 20°F (65°C) to about 3,000°F (1,650°C). Such articles may include, but are not limited to, turbine engine components such as nozzles, flaps, seals, shrouds, and the like, hypersonic engine components such as leading edges and heat exchangers, and hypersonic components such as hypersonic airfoil surfaces, and the like.

The articles may comprise any suitable material, such as, for example, silicon-containing substrates (i.e., silicon-containing ceramics, silicon-containing metal alloys, etc.) Suitable silicon-containing ceramics include, but are not limited to, silicon nitride, silicon carbide, silicon carbonitride, silicon oxycarbides, silicon carbide composites, silicon nitride composites, silicon oxynitrides, silicon aluminum oxynitrides, silicon nitride ceramic matrix composites, etc. Suitable silicon-containing metal alloys include, but are not limited to, molybdenum silicon alloys, niobium silicon alloys, iron silicon alloys, cobalt silicon alloys, nickel silicon alloys, tantalum silicon alloys, refractory metal silicides, etc.

Article 20 may include at least one surface 22 having an oxidation resistant coating 24 disposed thereupon according to any one of the processes described herein. In addition, the process of the present invention may be repeated so as to apply, deposit, etc., more than one layer of oxidation resistant coating upon the initial oxidation resistant coating 24. For example, an article 30 may include at least one surface 32 having a first oxidation resistant coating 34, a second oxidation resistant coating 36 and a third oxidation resistant coating 38.

Additionally, a top coat layer 40 of FIG. 3 may be disposed upon the silica-based coating(s) to impart additional protection from oxidation or steam at step 17 of FIG. 1. Such top coat layers may contain a refractory material including oxides, borides, carbides, silicides, silicates, or mixtures thereof. Suitable refractory oxide materials may include, but are not limited to, at least one of the following oxides: TaₓOy (where x = 1 to 3 and y= 1 to 5), NbₓOy (where x = 1 to 3 and y= 1 to 5), MgO, CaO, SrO, BaO, SiO₂, HfO₂, TiO₂, ZrO₂, Al₂O₃, Y₂O₃, La₂O₃, rare earth oxides, mixtures thereof and the like. Any one of a number of coating techniques known to one of ordinary skill in the art may be utilized. For example, suitable coating techniques to apply the top coat layer may include, but are not limited to, thermal spraying, chemical vapor deposition, physical vapor deposition, electrophoretic deposition, electrostatic deposition, preceramic polymer pyrolysis, sol-gel, slurry coating, dipping, air-brushing, sputtering, slurry painting, high velocity oxygen fuel processes, low pressure plasma spray processes, and the like. Optionally, step 17 may be repeated as often as necessary in order to achieve the desired properties of the top coat layer.

The oxidation resistant coatings of the present invention provide advantages over the prior art and overcome obstacles unlike prior art coatings. First, the use of oxygen scavengers dispersed throughout the resultant coating circumvents the problems associated with coefficient of thermal expansion mismatches such as spallation and cracking of the coating(s) that would occur if the layers were applied as continuous coating(s). As the coating(s) are exposed to oxidative operating conditions, the coating(s) erodes and expose the oxygen scavenger additives. The oxygen scavengers oxidize to form non-gaseous oxidation products such as SiO₂, Al₂O_{3,} B₂O₃, etc., which then add to and rebuild the coating. The glassy phase flows at elevated temperature to seal cracks and accommodate mismatches of the coefficient of thermal expansion of the various layers. As a result, the coating in turn resists spallation and cracking. Moreover, substrates that are coated with the coatings of the present invention demonstrate an oxidation resistance that is five to nine times better than uncoated substrates.

Second, components in hypersonic and/or gas turbine applications require environmental protection in different conditions that may or may not include water vapor. For example, scramjet engine leading edges require dry oxidation resistance up to and greater than 3,000°F (1,650°C) while cooled CMC flow path components, e.g., heat exchangers, require protection under relatively high water vapor conditions as known to one of ordinary skill in the art. Multiple layers of the oxidation resistant coatings of the present invention may serve both purposes. Multiple layers may provide additional protection against steam. The multiple layers may be used to modify the heat flux through the coatings, e.g., modify emissivity, reflectance, etc.

Certain preferred embodiments of the present invention are as follows:
1. A process for applying an oxidation resistant coating to an article, comprising:
   mixing at least two constituents to form a composition, a first constituent comprising a thermal expansion component comprising at least about 10% by volume to up to about 99% by volume of said composition, a second constituent comprising an oxygen scavenger comprising at least about 1% by volume to up to about 90% by volume of said composition;
   coating an article with said composition to form a coated article; and
   heat treating under an inert atmosphere said coated article to form an article having at least one oxidation resistant coating layer containing said at least one oxygen scavenger.
2. The process of embodiment 1, wherein said composition is selected from the group consisting of Si/SiOC, Ti/SiC, SiC/SiOC, yttrium disilicate/SiOC, SiC/Si/SiOC, Si/SiC and Si/Si3N4.
3. The process of embodiment 1, wherein said article comprises silicon nitride.
4. The process of embodiment 1, wherein said at least one oxygen scavenger is a silicide of any one or more of the following: molybdenum, tantalum, chromium, titanium, hafnium, zirconium, yttrium, and mixtures thereof; or a boride of any one or more of the following: molybdenum, tantalum, chromium, titanium, hafnium, zirconium, yttrium, and mixtures thereof; or both of any one or more of said silicides and any one or more of said borides.
5. The process of embodiment 1, wherein said at least one oxygen scavenger is a silicide of any one of the following: molybdenum, tantalum, chromium, titanium, hafnium, zirconium, yttrium, and mixtures thereof; and a boride of any one of the following: molybdenum, tantalum, chromium, titanium, hafnium, zirconium, yttrium, and mixtures thereof.
6. The process of embodiment 1, wherein mixing comprises a mechanical mixing process comprising at least one of the following: ball mixing, grinding, high energy milling, attrition milling, centrifugal mixing, and combinations thereof.
7. The process of embodiment 1, wherein coating comprises at least one of the following processes: co-spraying, thermal spraying, chemical vapor deposition, physical vapor deposition, electrophoretic deposition, electrostatic deposition, preceramic polymer pyrolysis, sol-gel, slurry coating, dipping, air-brushing, sputtering, painting, and combinations thereof.
8. The process of embodiment 1, further comprising drying said coated article at about 662°F (350°C) for about 30 minutes to about 60 minutes prior to heat treating said coated article.
9. The process of embodiment 1, wherein heat treating comprises heating said coated article at about 1,000°F (538°C) to about 3,100°F (1,700°C) for a period of time sufficient to form said oxidation resistant coating.
10. The process of embodiment 1, wherein said silica based material comprises a particle size range of about 150 mesh to about 325 mesh.
11. The process of embodiment 1, wherein said at least one oxygen scavenger comprises a particle diameter size range of about 0.05 microns to about 50 microns.
12. The process of embodiment 1, further comprising applying upon said oxidation resistant coating layer a top coat layer comprising at least one of the following: refractory oxide material, refractory carbide material, refractory boride material, refractory silicide material, and mixtures thereof.
13. The process of embodiment 12, wherein said refractory oxide material is selected from the group consisting of TaₓOy (where x = 1 to 3 and y = 1 to 5), NbₓOy (where x = 1 to 3 and y = 1 to 5), MgO, CaO, SrO, BaO, SiO₂, HfO₂, TiO₂, 2rO₂, Al₂O₃, Y₂O₃, La₂O₃, rare earth oxides, and mixtures thereof.
14. The process of embodiment 12, wherein applying comprises at least one of the following processes: thermal spraying, chemical vapor deposition, physical vapor deposition, electrophoretic deposition, electrostatic deposition, preceramic polymer pyrolysis, sol-gel, slurry coating, dipping, air-brushing, sputtering, slurry painting, high velocity oxygen fuel spraying, and low pressure plasma spraying.
15. A coated article comprising:
   an article having at least one surface having disposed thereupon an oxidation resistant coating comprising at least two constituents to form a composition, a first constituent comprising at least one thermal expansion component comprising at least about 10% by volume to up to about 99% by volume of said composition, a second constituent comprising at least one oxygen scavenger comprising at least about 1% by volume to up to about 90% by volume of said composition.
16. The coated article of embodiment 15, wherein said composition is selected from the group consisting of Si/SiOC, Ti/SiC, SiC/SiOC, yttrium disilicate/SiOC, SiC/Si/SiOC, Si/SiC and Si/Si3N4.
17. The coated article of embodiment 15, wherein said at least one oxygen scavenger is a silicide of any one or more of the following: molybdenum, tantalum, chromium, titanium, hafnium, zirconium, yttrium, and mixtures thereof; or a boride of any one or more of the following: molybdenum, tantalum, chromium, titanium, hafnium, zirconium, yttrium, and mixtures thereof; or both of any one or more of said silicides and any one or more of said borides.
18. The coated article of embodiment 15, further comprising a top coat layer disposed upon said oxidation resistant coating, said top coat layer comprising at least one of the following: refractory oxide material, refractory carbide material, refractory boride material, refractory silicide material, and mixtures thereof.
19. The coated article of embodiment 18, wherein said refractory oxide material is selected from the group consisting of TaₓOy (where x = 1 to 3 and y = 1 to 5), NbₓOy (where x = 1 to 3 and y = 1 to 5), MgO, CaO, SrO, BaO, SiO₂, HfO₂, TiO₂, ZrO₂, Al₂O₃, Y₂O₃, La₂O₃, rare earth oxides, and mixtures thereof.
20. The coated article of embodiment 15, wherein said article comprises any one of the following: silicon containing ceramics, silicon containing alloys, and mixtures thereof.
21. The coated article of embodiment 20, wherein said silicon containing ceramics are selected from the group consisting of silicon nitride, silicon carbide, silicon carbonitride, silicon oxycarbides, silicon carbide composites, silicon nitride composites, silicon oxynitrides, silicon aluminum oxynitrides, silicon nitride ceramic matrix composites, and mixtures thereof.
22. The coated article of embodiment 20, wherein said silicon containing alloys are selected from the group consisting of molybdenum silicon alloys, niobium silicon alloys, iron silicon alloys, iron silicon alloys, cobalt silicon alloys, nickel silicon alloys, tantalum silicon alloys, refractory metal silicon alloys, and mixtures thereof.
23. The coated article of embodiment 15, wherein said oxidation resistant coating has a thickness of between about 0.1 and about 300 mils.
24. The coated article of embodiment 15, wherein said oxidation resistant coating has a thickness of between about 0.1 and about 10 mils.
25. The coated article of embodiment 15, wherein the article comprises any one of the following: turbine engine components, hypersonic engine components, and hypersonic components.
26. The coated article of embodiment 15, wherein the article comprises any one of the following: nozzles, flaps, seals and shrouds of turbine engines; leading edges and heat exchangers of hypersonic engines; and airfoil surfaces of hypersonic components.

One or more embodiments of the disclosure have been described. Nevertheless, it will be understood that various modifications may be made without departing from the spirit and scope of the disclosure. Accordingly, other embodiments are within the scope of the following claims.

## Claims

1. A process for applying an oxidation resistant coating to an article, comprising:
mixing at least two constituents to form a composition, a first constituent comprising a thermal expansion component comprising at least about 10% by volume to up to about 99% by volume of said composition, a second constituent comprising an oxygen scavenger comprising at least about 1% by volume to up to about 90% by volume of said composition;
coating an article with said composition to form a coated article; and
heat treating under an inert atmosphere said coated article to form an article having at least one oxidation resistant coating layer containing said at least one oxygen scavenger.

2. The process of claim 1, wherein said composition is selected from the group consisting of Si/SiOC, Ti/SiC, SiC/SiOC, yttrium disilicate/SiOC, SiC/Si/SiOC, Si/SiC and Si/Si3N4, and/or wherein said article comprises silicon nitride.

3. The process of claim 1 or claim 2, wherein said at least one oxygen scavenger is a silicide of any one or more of the following: molybdenum, tantalum, chromium, titanium, hafnium, zirconium, yttrium, and mixtures thereof; and/or a boride of any one or more of the following: molybdenum, tantalum, chromium, titanium, hafnium, zirconium, yttrium, and mixtures thereof.

4. The process of any preceding claim, wherein mixing comprises a mechanical mixing process comprising at least one of the following: ball mixing, grinding, high energy milling, attrition milling, centrifugal mixing, and combinations thereof.

5. The process of any preceding claim, wherein coating comprises at least one of the following processes: co-spraying, thermal spraying, chemical vapor deposition, physical vapor deposition, electrophoretic deposition, electrostatic deposition, preceramic polymer pyrolysis, sol-gel, slurry coating, dipping, air-brushing, sputtering, painting, and combinations thereof.

6. The process of any preceding claim, further comprising drying said coated article at about 662°F (350°C) for about 30 minutes to about 60 minutes prior to heat treating said coated article, and/or wherein heat treating comprises heating said coated article at about 1,000°F (538°C) to about 3,100°F (1,700°C) for a period of time sufficient to form said oxidation resistant coating.

7. The process of any preceding claim, wherein said silica based material comprises a particle size range of about 150 mesh to about 325 mesh, and/or wherein said at least one oxygen scavenger comprises a particle diameter size range of about 0.05 microns to about 50 microns.

8. The process of any preceding claim, further comprising:
applying upon said oxidation resistant coating layer a top coat layer comprising at least one of the following:
refractory oxide material, refractory carbide material, refractory boride material, refractory silicide material, and mixtures thereof,
and/or
wherein applying comprises at least one of the following processes: thermal spraying, chemical vapor deposition, physical vapor deposition, electrophoretic deposition, electrostatic deposition, preceramic polymer pyrolysis, sol-gel, slurry coating, dipping, air-brushing, sputtering, slurry painting, high velocity oxygen fuel spraying, and low pressure plasma spraying,
preferably wherein said refractory oxide material is selected from the group consisting of TaₓOy (where x = 1 to 3 and y = 1 to 5), NbₓOy (where x = 1 to 3 and y = 1 to 5), MgO, CaO, SrO, BaO, SiO₂, HfO₂, TiO₂, ZrO₂, Al₂O₃, Y₂O₃, La₂O₃, rare earth oxides, and mixtures thereof.

9. A coated article (e.g. a coated article made by the process of any preceding claim) comprising:
an article having at least one surface having disposed thereupon an oxidation resistant coating comprising at least two constituents to form a composition, a first constituent comprising at least one thermal expansion component comprising at least about 10% by volume to up to about 99% by volume of said composition, a second constituent comprising at least one oxygen scavenger comprising at least about 1% by volume to up to about 90% by volume of said composition.

10. The coated article of claim 9, wherein said composition is selected from the group consisting of Si/SiOC, Ti/SiC, SiC/SiOC, yttrium disilicate/SiOC, SiC/Si/SiOC, Si/SiC and Si/Si3N4.

11. The coated article of any one of claims 9 or 10,
wherein said at least one oxygen scavenger is a silicide of any one or more of the following: molybdenum, tantalum, chromium, titanium, hafnium, zirconium, yttrium, and mixtures thereof; and/or a boride of any one or more of the following: molybdenum, tantalum, chromium, titanium, hafnium, zirconium, yttrium, and mixtures thereof.

12. The coated article of any one of claims 9 to 11, further comprising a top coat layer disposed upon said oxidation resistant coating, said top coat layer comprising at least one of the following: refractory oxide material, refractory carbide material, refractory boride material, refractory silicide material, and mixtures thereof, preferably wherein said refractory oxide material is selected from the group consisting of TaₓOy (where x = 1 to 3 and y = 1 to 5), NbₓOy (where x = 1 to 3 and y = 1 to 5), MgO, CaO, SrO, BaO, SiO₂, HfO₂, TiO₂, ZrO₂, Al₂O₃, Y₂O₃, La₂O₃, rare earth oxides, and mixtures thereof.

13. The coated article of any one of claims 9 to 12,
wherein said article comprises any one of the following and mixtures thereof:
a) silicon containing ceramics, preferably wherein said silicon containing ceramics are selected from the group consisting of silicon nitride, silicon carbide, silicon carbonitride, silicon oxycarbides, silicon carbide composites, silicon nitride composites, silicon oxynitrides, silicon aluminum oxynitrides, silicon nitride ceramic matrix composites, and mixtures thereof,
b) silicon containing alloys, preferably wherein said silicon containing alloys are selected from the group consisting of molybdenum silicon alloys, niobium silicon alloys, iron silicon alloys, iron silicon alloys, cobalt silicon alloys, nickel silicon alloys, tantalum silicon alloys, refractory metal silicon alloys, and mixtures thereof.

14. The coated article of any one of claims 9 to 13,
wherein said oxidation resistant coating has a thickness of between about 0.1 and about 300 mils, preferably wherein said oxidation resistant coating has a thickness of between about 0.1 and about 10 mils.

15. The coated article of any one of claims 9 to 14,
wherein the article comprises any one of the following: turbine engine components, hypersonic engine components, and hypersonic components, and/or wherein the article comprises any one of the following: nozzles, flaps, seals and shrouds of turbine engines; leading edges and heat exchangers of hypersonic engines; and airfoil surfaces of hypersonic components.
